# EUROPEAN PATENT APPLICATION

(11) **EP 1 936 673 A1**
(43) Date of publication of application: **25.06.2008**
(21) Application number: 06811509.6
(22) Date of filing: 10.10.2006
(51) Int. Cl.: H01L 21/304, B24B 37/00, C09K 3/14

(54) **POLISHING SOLUTION FOR CMP AND METHOD OF POLISHING**

(30) Priority: 12.10.2005 JP 2005298031
(71) Applicant: Hitachi Chemical Co., Ltd., Shinjuku-ku, Tokyo 163-0449 (JP)
(72) Inventor: SHINODA, Takashi c/o Hitachi Chemical Co., Ltd. Yamazaki Works, Ibaraki 317-8555 (JP); NOBE, Shigeru c/o Hitachi Chemical Co., Ltd. Yamazaki Works, Ibaraki 317-8555 (JP); SAKURADA, Takafumi c/o Hitachi Chemical Co., Ltd. Yamazaki Works, Ibaraki 317-8555 (JP); OOMORI, Yoshikazu c/o Hitachi Chemical Co., Ltd. Yamazaki Works, Ibaraki 317-8555 (JP); KIMURA, Tadahiro c/o Hitachi Chemical Co., Ltd. Yamazaki Works, Ibaraki 317-8555 (JP)
(74) Representative: HOFFMANN EITLE
(86) International application number: PCT/JP2006/320196
(87) International publication number: WO 2007/043517

(57) **Abstract**

The invention provides polishing slurry for CMP for suppressing corrosion of wiring lines of a conductive substance, or for suppressing bimetallic corrosion of a barrier conductor and conductive substance, by suppressing electrons from being transferred at near the boundaries between a barrier conductor and a conductive substance such as copper. The invention provides polishing slurry for CMP for polishing at least a conductor layer and a conductive substance layer in contact with the conductor layer, wherein the absolute value of the potential difference between the conductive substance and the conductor at 50 ± 5°C is 0.25 V or less in the polishing slurry when a positive electrode and a negative electrode of a potentiometer are connected to the conductive substance and the conductor, respectively. The polishing slurry for CMP preferably comprises at least one compound selected from heterocyclic compounds containing any one of hydroxyl group, carbonyl group, carboxyl group, amino group, amide group and sulfinyl group, and containing at least one of nitrogen and sulfur atoms.

## Description

### TECHNICAL FIELD

The invention relates to polishing slurry for CMP used for polishing in such as a wiring line forming process of a semiconductor device and a polishing method.

### BACKGROUND ART

Fine processing techniques have been developed in accordance with high integration and high performance of semiconductor integrated circuits (abbreviated as LSIs hereinafter) in recent years. Chemical mechanical polishing (abbreviated as CMP hereinafter) is one of these techniques that have been frequently used in an LSI manufacturing process, particularly for planarizing interlayer insulation films, for forming metal plugs and for forming embedded wiring lines in a process for forming multi-layer wiring lines. This technique is disclosed in USP No. 4,944,836.

Uses of copper and copper alloys as conductive substances to be wiring materials have been attempted in recent years in order to attain high performance of LSIs. However, while fine processing by a dry etching method has been frequently employed for forming conventional aluminum alloy wiring lines, the method is hardly applicable for forming the wiring line of Cu or Cu alloy. Accordingly, a so-called damascene process has been mainly used, wherein thin films of copper or copper alloys are piled on an insulation layer and embedded in grooves formed on the insulation layer in advance, and an embedded wiring line is formed by removing the thin films at portions other than the grooves by CMP. This technique is disclosed in Japanese Patent No. 1,969,537.

A conventional method of metal CMP for polishing the wiring metals of copper or copper alloys comprises the steps of bonding a polishing cloth (pad) on a circular polishing platen, pressing the surface of a substrate comprising a metal layer formed thereon onto the surface of the polishing cloth while the polishing cloth is impregnated with a metal polishing slurry, rotating the polishing platen while a predetermined pressure (referred to as a polishing pressure hereinafter) is applied from the back face of the polishing cloth, and removing metal layers on convex portions by relative mechanical friction between the polishing slurry and metal layer on convex portions.

The metal polishing slurry used for CMP usually comprises an oxidizing agent and abrasive grains, and a metal oxide dissolving agent and a protective film forming agent are added to the polishing slurry, if necessary. The basic mechanism of polishing is considered to comprise the steps of oxidizing the surface of the metal layer with the oxidizing agent, and shaving the oxide layer with the abrasive grains. Since the oxide layer on the surface of the metal in the concave portion is seldom in contact with the polishing pad and is not subjected to the effect of shaving with the abrasive grains, the metal layer on the convex portion is removed with the advance of CMP and the surface of the substrate is planarized. Details of this process is described in Journal of Electrochemical Society, Vol. 138, No. 11 (1991), p. 3460-3464.

For enhancing the polishing speed by CMP, it is considered to be effective to blend a metal oxide dissolving agent. It is interpreted that the shaving effect with the abrasive grains is enhanced by dissolving grains of the metal oxide shaved with the abrasive grains into the polishing slurry (this process is referred to as "etching"). However, while the polishing speed by CMP increases by blending the metal oxide dissolving agent, the surface of the metal layer in the concave portion is further oxidized when the surface of the metal layer in the concave portion is exposed by etching, and etching of the metal layer in the concave portion advances by repetition of this process. Consequently, the central portion of the embedded metal wiring line is depressed like a dish after polishing (a phenomenon called dishing hereinafter), and the effect of planarization is impaired.

For preventing dishing from occurring, a protective film forming agent is further blended. The protective film forming agent serves for forming a protective film on the oxide layer on the surface of the metal layer in order to prevent the oxide layer from being dissolved in the polishing slurry. This protective layer is desired to be readily shaved so that the polishing speed by CMP is not lowered.

For suppressing dishing and corrosion of copper and copper alloys during polishing and for forming highly reliable LSI wiring lines, polishing slurry for CMP containing a metal oxide dissolving agent comprising amino acetic acid such as glycine or sulfuric acid amide and BTA as a protective film forming agent are used in a proposed method. This technique is described in Japanese Patent No. 3,397,501.

On the other hand, a layer as a barrier conductor layer (often referred to as a barrier layer hereinafter) of, for example, tantalum compound such as tantalum, tantalum alloys or tantalum nitride is formed under the wiring metal such as copper or a copper alloy for preventing copper from diffusing into the interlayer insulation film and for improving adhesion. Accordingly, the exposed barrier layer should be removed by CMP at the portions other than the wiring portion for embedding copper or a copper alloy. However, since the conductor of the barrier layer is more rigid than copper or copper alloy, a sufficient polishing speed cannot be obtained by combining polishing materials for copper or copper alloy, and planarity is often impaired. Therefore, a two-stage polishing method comprising a first step for polishing the wiring metal and a second step for polishing the barrier layer has been examined.

The interlayer insulation film should be also polished in order to improve planarity in the second polishing step for polishing the barrier layer. While a silicon oxide film was mainly used as the interlayer insulation film, silicon materials or organic polymers having a lower dielectric constant than silicon oxide film have been attempted to be used in recent years in order to attain high performance of LSIs.

### SUMMARY OF THE INVENTION

In so-called isolated copper fine wiring lines, in particular wiring lines having a wiring width of 0.5 µm or less and a space of 5.0 µm or more between the wiring lines, on the substrate after a second polishing step for polishing the barrier layer, tips of the wiring lines and boundaries between the barrier conductor and copper are liable to be corroded, or small steps (recesses) are liable to appear. Such corrosion and recess may cause troubles such as breakage of the wiring lines, decrease of the yield of the semiconductor device and lowering of reliability of the semiconductor device in the production of high performance semiconductor devices in which formation of the fine wiring lines is inevitable and which are required to be highly reliable. Bimetallic corrosion of barrier conductor and copper is considered to be a cause for such corrosion. When the potential difference between the barrier conductor and copper increases to a certain extent, electrons and copper ions may be dissolved into the polishing slurry from the surface of copper in the vicinity of boundaries between the barrier conductor and copper, and the ions and electrons may cause corrosion.

In view of the above-mentioned problems, the invention provides polishing slurry for CMP capable of suppressing bimetallic corrosion between a barrier conductor and conductive substance, or suppressing wiring lines of conductive substances from being corroded, by suppressing electrons from transferring at near boundaries between the barrier conductor and conductive substances such as copper.

Suppression of corrosion of the wiring lines of the conductive substance by CMP polishing slurry is confirmed by measuring a potential difference between the barrier conductor and conductive substance with interposition of the polishing slurry. It is desirable that the absolute value of the potential difference is small.

The polishing slurry of the invention is featured in that the absolute value of the potential difference between the conductor for the barrier layer and conductive substance is small. A protective layer is formed on the surface of the conductive substance when the polishing slurry contains at least one compound selected from heterocyclic compounds containing anyone of hydroxyl, carbonyl, carboxyl, amino, amide and sulfinyl groups, and containing at least one of nitrogen and sulfur atoms, or contains at least one compound selected from amine compounds, amide compounds and sulfoxide compounds. Such polishing slurry inhibits electrons and ions of the conductive material from being dissolved in the polishing slurry from the surface of the conductive substance at near the boundary between the barrier conductor and conductive substance, so that bimetallic corrosion between the barrier conductor and conductive substance can be suppressed.

The invention relates to polishing slurry for CMP according to (1) to (21) below:

(1) polishing slurry for CMP for polishing at least a conductor layer and a conductive substance layer in contact with the conductor layer, wherein the absolute value of the potential difference between the conductive substance and conductor at 50 ± 5°C is 0.25 V or less in the polishing slurry when a positive electrode and a negative electrode of a potentiometer are connected to the conductive substance and conductor, respectively;

(2) the polishing slurry for CMP according to (1) comprising an additive for reducing the absolute value of the potential difference between the conductor and conductive substance;

(3) the polishing slurry for CMP according to (2) comprising, as the additive for reducing the absolute value of the potential difference, at least one compound selected from heterocyclic compounds containing any one of hydroxyl group, carbonyl group, carboxyl group, amino group, amide group and sulfinyl group, and containing at least one of nitrogen and sulfur atoms;

(4) the polishing slurry for CMP according to (3), wherein the solubility in the polishing slurry of a copper complex of the heterocyclic compound formed by adding copper (II) sulfate to the polishing slurry is 1% by weight or more at a liquid temperature of 25°C;

(5) the polishing slurry for CMP according to (2) comprising at least one compound selected from amine compounds, amide compounds and sulfoxide compounds as the additive for reducing the absolute value of the potential difference;

(6) the polishing slurry for CMP according to any one of (3) to (5) comprising at least one compound selected from heterocyclic compounds containing any one of hydroxyl group, carbonyl group, carboxyl group, amino group, amide group and sulfinyl group, and containing at least one of nitrogen and sulfur atoms; and at least one compound selected from amine compounds, amide compounds and sulfoxide compounds.

(7) the polishing slurry for CMP according to any one of (1) to (6), wherein the conductor contains at least one selected from tantalum, tantalum nitride, tantalum alloys and other tantalum compounds, titanium, titanium nitride, titanium alloys and other titanium compounds, tungsten, tungsten nitride, tungsten alloys and other tungsten compounds, ruthenium and other ruthenium compounds; and the conductive substance is copper, copper alloys, copperoxides, oxides of the copper alloy, tungsten, tungsten alloys, silver, silver alloys or gold;

(8) the polishing slurry for CMP according to any one of (1) to (7), wherein the conductive substance is copper;

(9) polishing slurry for CMP forpolishing a surface comprising, on the surface thereof,
(a) a conductive substance mainly comprising copper; and
(b) at least one conductor selected from tantalum, tantalum nitride, tantalum alloys and other tantalum compounds, titanium, titanium nitride, titanium alloys and other titanium compounds, tungsten, tungsten nitride, tungsten alloys and other tungsten compounds, ruthenium and other ruthenium compounds, wherein the absolute value of the potential difference between (a) the conductive substance and (b) the conductor at 50 ± 5°C is 0.25 V or less in the polishing slurry when a positive electrode of a potentiometer is connected to (a) the conductive substance and a negative electrode is connected to (b) the conductive substance;

(10) polishing slurry for CMP for polishing a substrate comprising an interlayer insulation film having concave portions and convex portions on the surface, a barrier conductor layer for covering the interlayer insulation film along the surface thereof, and a conductive substance layer mainly comprising copper for covering the barrier conductor layer and filling the concave portion,
wherein the polishing slurry contains at least one heterocyclic compounds containing any one of hydroxyl group, carbonyl group, carboxyl group, amino group, amide group and a sulfinyl group, and containing at least one of nitrogen and sulfur atoms;

(11) polishing slurry for CMP for polishing a surface comprising, on the surface thereof,
(a) a conductive substance mainly comprising copper, and
(b) at least one conductor selected from tantalum, tantalum nitride, a tantalum alloy, other tantalum compounds, titanium, titanium nitride, a titanium alloy, other titanium compounds, tungsten, tungsten nitride, a tungsten alloy, other tungsten compounds, ruthenium and other ruthenium compounds,
wherein the polishing slurry contains at least one heterocyclic compounds containing any one of a hydroxyl group, carbonyl group, carboxyl group, amino group, amide group and sulfinyl group, and containing at least one selected from nitrogen and sulfur atoms;

(12) polishing slurry for CMP for polishing a substrate comprising an interlayer insulation film having convex portions and concave portions on the surface, a barrier conductor layer for covering the interlayer insulation film along the surface thereof, and a conductive substance layer mainly comprising copper for covering the barrier conductor layer and f il ling the concave portion,
wherein the polishing slurry contains at least one compound selected from amine compounds, amide compounds and sulfoxide compounds;

(13) polishing slurry for CMP for polishing a surface comprising,
(a) a conductive substance mainly comprising copper, and
(b) at least one conductor selected from tantalum, tantalum nitride, tantalum alloys and other tantalum compounds, titanium, titanium nitride, titanium alloys and other titanium compounds, tungsten, tungsten nitride, tungsten alloys and other tungsten compounds, ruthenium and other ruthenium compounds,
wherein the polishing slurry contains at least one compound selected from amine compounds, amide compounds and sulfoxide compounds;

(14) the polishing slurry for CMP according to any one of (1) to (13) containing abrasive grains;

(15) the polishing slurry for CMP according to (14), wherein the abrasive grains are at least one selected from silica, alumina, ceria, titania, zirconia and germania;

(16) the polishing slurry for CMP according to any one of (1) to (15) containing a metal oxide dissolving agent and water;

(17) the polishing slurry for CMP according to (16), wherein the metal oxide dissolving agent is at least one compound selected from organic acids, organic acid esters, ammonium salts of organic acids and inorganic acids;

(18) the polishing slurry for CMP according to any one of (1) to (17) containing a metalcorrosion preventive agent;

(19) the polishing slurry for CMP according to (18), wherein the metal corrosionpreventive agent is at least one compound selected from compounds having a triazole frame, compounds having a benzotriazole frame, compounds having a pyrazole frame, compounds having a pyramidine frame, compounds having an imidazole frame, compounds having a guanidine frame and compounds having a thiazole frame;

(20) the polishing slurry for CMP according to any one of (1) to (19) containing a metal oxidizing agent; and

(21) the polishing slurry for CMP according to (20), wherein the metal oxidizing agent is at least one selected from hydrogen peroxide, nitric acid, potassium periodate, hypochlorous acid and aqueous ozone.

The invention further provides a polishing method according to (22) to (25) below:

(22) a polishing method comprising the steps of:
exposing a barrier conductor layer of convexe portions by polishing a conductive substance layer of a substrate comprising an interlayer insulation film having concave portions and convex portions on the surface, a barrier layer for covering the interlayer insulation film along the surface thereof, and a conductive substance layer for covering the barrier layer and filling the concave portion (a first polishing step); and
exposing the interlayer insulation film of the convex portion by chemical mechanical polishing of at least the barrier layer and conductive substance layer in the concave portion while supplying the polishing slurry for CMP according to any one of (1) to (21) (a second polishing step).

(23) the polishing method according to (22), wherein the interlayer insulation film is a silicon film or an organic polymer film;

(24) the polishing method according to (22) or (23), wherein the conductive substance mainly comprises copper; and

(25) the polishing method according to any one of (22) to (24), wherein the barrier conductor layer is provided for preventing the conductive substance from being diffused into the interlayer insulation film, and contains at least one selected from tantalum, tantalum nitride, tantalum alloys and other tantalum compounds, titanium, titanium nitride, titanium alloys and other titanium compounds, tungsten, tungsten nitride, tungsten alloys and other tungsten compounds, ruthenium and other ruthenium compounds.

The disclosure of the present application is related to the theme described in Japan Patent Application No. 2005-298031, the disclosure of which is incorporated herein by way of references.

### BRIEF DESCRIPTION OF THE DRAWINGS [0043]

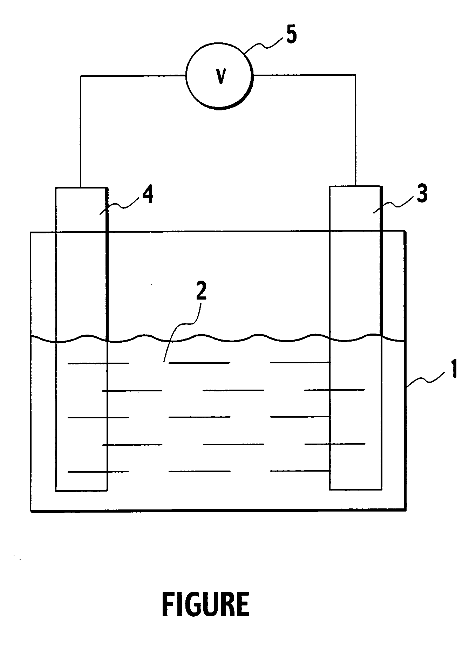

[FIGURE 1] FIGURE schematically illustrates an example of the method for measuring the potential difference of the invention.

### (DESCRIPTION OF REFERENCE NUMERALS)

- 1: glass beaker
- 2: polishing slurry for CMP
- 3: barrier conductor substrate
- 4: copper substrate
- 5: potentiometer

### BEST MODE OF CARRYING OUT THE INVENTION

The polishing slurry for CMP of the invention is used for polishing at least a conductor layer and a conductive substance layer in contact with the conductor layer, and exhibits a small absolute value of the potential difference between the conductor and conductive material in the polishing slurry. This feature permits fine wiring lines of the conductive substance tobe suppressed from being corroded. The absolute value of the potential difference between the conductor and conductive substance is preferably suppressed to be 0.25 V or less.

The polishing slurry of the invention can be used forpolishing a surface having the conductive substance described below and conductor described below on the surface. Specifically, an example of the polishing surface is a surface of a substrate comprising an interlayer insulation film having convex portions and concave portions on the surface, a barrier conductor layer covering the interlayer insulation film along the surface thereof, and a conductive substance layer comprising copper as a principal component for covering the barrier conductive layer by filling the concave portion in a step for forming a wiring portion of a semiconductor device.

Examples of the conductive substance include substances mainlycomprisingmetals suchas copper, copper alloys, copper oxides, oxides of the copper alloy, tungsten, tungsten alloys, silver, silver alloys and gold. Conductive substances mainly comprising copper (referred to as conductive substance (a) hereinafter) are preferable, and examples of them include copper, copper alloys, copper oxides and oxides of the copper alloy. More preferably, the conductive substance is copper. An example of the conductive substance layer composed of such conductive substance is a metal layer for wiring parts in the semiconductor device.

Examples of the conductor include at least one (referred to as conductor (b) hereinafter) selected from tungsten, tungsten nitride, tungsten alloys and other tungsten compounds, titanium, titanium nitride, titanium alloys and other titanium compounds, tantalum, tantalum nitride, tantalum alloys and other tantalum compounds, ruthenium and other ruthenium compounds. The conductor layer may be composed of either conductor (b) or a laminated layer containing the conductor (b). An example of the conductor layer is a barrier conductor layer formed for preventing conductive substances from diffusing into the interlayer insulation film, and for improving adhesion between the interlayer insulation film and conductive substance in the semiconductor device.

The polishing slurry for CMP of the invention preferably contains an additive for reducing the absolute value of the potential difference between the conductor and conductive substance. The polishing slurry also preferably contains abrasive grains, a metal oxide dissolving agent, a metal corrosion preventive agent and water, more preferably a metal oxidation agent. A solvent capable of being mixed with water such as an organic solvent, a water-soluble polymer and a coloring agent may be blended, if necessary.

The polishing slurry of the invention preferably exhibits an absolute value of the potential difference between the conductive substance and conductor of 0.25 V or less in the polishing slurry. Bimetallic corrosion between the conductive substance and conductor, or corrosion of the wiring line of the conductive substance, hardly occurs when the absolute value of the potential difference is 0.25 V or less. When the potential difference exceeds 0.25 V, on the other hand, electrons and ions of the conductive substance are dissolved out of the surface of the conductive substance at near the boundary between the conductor and conductive substance into the polishing slurry since the absolute value of the potential difference between the conductor and conductive substance is substantially high, and the wiring lines of the conductive substance are liable to be corroded. The wiring lines of the conductive substance are more hardly corroded when the absolute value of the potential difference is 0.20 V or less.

The potential difference between the conductive substance and conductor is measured by the following procedure in the invention. The polishing slurry (about 50 ml) is filled in a beaker with a volume of about 100 ml, and is warmed to 50 ± 5°C in a constant temperature bath. The polishing slurry is used for CMP, and additives such as a metal oxidizing agent is actually added if it is to be added immediately before chemical mechanical polishing. A silicon substrate on which a film of the conductive substance is deposited by sputtering (referred to as a substrate of the conductive substance hereinafter) and a silicon substrate on which a conductor film such as a tantalum film is deposited by sputtering (referred to as a conductor substrate hereinafter) are cut into an appropriate size, and a positive electrode and negative electrode are connected to the substrate of the conductive substance and conductor substrate, respectively. The substrate of the conductive substance and the conductor substrate are placed with a distance apart so as to avoid direct contact between them, a minimum value of the absolute values of the potential difference during the time period of 30 seconds after dipping the substrates into the polishing slurry is measured as the absolute value of the potential difference. While the material of the beaker is not particularly limited so long as it does not react with the polishing slurry, the beaker is preferably made of a glass or plastic.

An example of the method for reducing the absolute value of the potential difference between the conductor and conductive substance is to add an additive to the polishing slurry, wherein the additive has an effect for suppressing electrons from being transferred at near the boundary between the conductor and conductive substance. While the additive having the effect for suppressing electrons from being transferred at near the boundary between the conductor and conductive substance, and for reducing the absolute value of the potential difference between the conductor and conductive substance (referred to as an additive for reducing the potential difference hereinafter), is not particularly limited, the additive preferably contains at least one compound (A) selected from amine compounds, amide compounds and sulfoxide compounds. Or, the additive preferably contains at least one compound (B) selected from heterocyclic compounds containing any one of hydroxyl group, carbonyl group, carboxyl group, amino group, amide group and sulfinyl group, and containing at least one of nitrogen and sulfur atoms. Compound (A) and compound (B) may be used together.

Examples of the amine compound of the compounds (A) include alkanol amines such as monoethanolamine, N,N-dimethylethanolamine, N-methyl diethanolamine and triethanolamine; aliphatic amines such as n-propylamine, butylamine, dibutylamine, tributylamine, 1,4-butanediamine, triethylenetetramine and cyclohexylamine; and aromatic amines such as aniline, N-methyl aniline, N-ethyl aniline and aromatic polyamine.

Examples of the amide compound include dimethylformamide, dimethylacetamide and hexamethyl phosphoric amide, while an example of the sulfoxide compound is dimethylsulfoxide.

Examples of the heterocyclic compounds of compounds (B) include pyrazine amide, pyrazine-2,3-dicarboxylic acid monoamide, pyradine carboxylic acid, 2,3-pyradine dicarboxylic acid, 1-hydroxybenzotriazole, 2-amino-2-thiazoline acetic acid, 3,5-dimethylpyrazole, pyrazine carboxyamide, 4-amino-1,2,4-triazole and 1,2,4-triazol-3-one.

Examples of the additive for reducing the potential difference preferably include monoethanolamine, ethylamine, n-propylamine, n-butylamine, dibutylamine, tributylamine, 1,4-butanediamine, cyclohexylamine, triethylenetetramine, N,N-dimethyl ethanolamine, N-methyl diethanolamine, triethanolamine, hexamethyl phosphoric triamide, aniline, N-methyl aniline, N-ethyl aniline, dimethylformamide, dimethylacetamide, dimethylsulfoxide, pyrazine amide, pyrazine-2,3-dicarboxylic acid monoamide, pyrazine carboxylic acid, 2,3-pyrazine dicarboxylic acid, 1-hydroxybenzotriazole, 2-amino-2-thiazoline acetic acid, 3,5-dimethyl pyrazole, pyrazine carboxamide, 4-amino-1,2,4-triazole and 1,2,4-triazol-3-one; more preferably monoethanolamine, N,N-dimethyl ethanolamine, N-methyl diethanolamine, triethanolamine, n-butylamine, hexamethyl phosphoric triamide, aniline, cyclohexylamine, dimethylsulfoxide, dimethylacetamide, pyrazine carboxylic acid, 2,3-pyrazine dicarboxylic acid, 1-hydroxybenzotriazole, 2-amino-2-thiazoline acetic acid, 3,5-dimethyl pyrazole, pyrazine carboxamide, 4-amino-1,2,4-triazole and 1,2,4-triazol-3-one; and further preferably N-dimethyl ethanolamine, triethanolamine, aniline, 4-amino-1,2,4-triazole, 1-hydroxybenzotriazole, pyrazine carboxylic acid and 2,3-pyrazine dicarboxylic acid.

One of these compounds may be used alone, or a mixture of a plurality of them may be used.

When a heterocyclic compound (compound B) containing any one of hydroxyl group, carbonyl group, carboxyl group, amino group, amide group and sulfinyl group, and containing at least one of nitrogen and sulfur atoms is used as the additive for reducing the potential difference in the polishing slurry of the invention, the solubility in the polishing slurry of a copper complex formed by adding copper (II) sulfate to the polishing slurry is preferably 1% by weight or more at a liquid temperature of 25°C. The absolute value of the potential difference decreases when the heterocyclic compound having a solubility of the complex of 1% by weight or more is added, while the absolute value of the potential difference tends to be increased when a heterocyclic compound having a solubility of the complex of less than 1% by weight is blended.

The solubility is measured as follows in the invention. An appropriate amount of copper (II) sulfate is added to the polishing slurry for CMP, the temperature of the liquid is maintained at 25°C after thoroughly stirring the liquid, and precipitates, if any, in the vessel are observed after allowing the solution to stand for 60 minutes. The amount of addition of copper (II) sulfate is preferably from 0 to 10 g (excluding 0 g) per 100 g of the polishing slurry, and an amount of addition of a half mole of the molar concentration of the heterocyclic compound (compound B) in the polishing slurry is particularlypreferable so that the heterocyclic compound (compound B) and the copper (II) ion form a complex at a molar concentration of 2 to 1.

Examples of the abrasive grains of the invention include inorganic abrasive grains such as silica, alumina, zirconia, ceria, titania, germania, and silicon carbide grains, and organic abrasive grains such as polystyrene, polyacrylic and polyvinyl chloride grains. Silica, alumina, zirconia, ceria, titania and germania are preferable; colloidal silica and colloidal alumina with an average particle diameter of 70 nm or less that exhibit good dispersion stability in the polishing slurry and fewer incidence of scratches caused by CMP are preferable; and colloidal silica and colloidal alumina with an average particle diameter of 40 nm or less are more preferable. The particles preferably comprise aggregates of less than 2 of primary particles in average, more preferably particles comprising aggregates of less than 1.2 of primary particles in average. The standard deviation of the average of distribution of the particle diameter is preferably 10 nm or less, more preferably 5 nm or less. One of these particles may be used alone, or a mixture of the plural particles may be used.

A known method for producing colloidal silica is hydrolysis of silicon alkoxide or ion-exchange of sodium silicate, while a known method for producing colloidal alumina is hydrolysis of aluminum nitrate. Colloidal silica produced by hydrolysis of silicon alkoxide is used most from the view point of controllability of the particle diameter and the content of impurities alkali metals. Generally used silicon alkoxide includes TEMS (tetramethoxy silane) andTEOS (tetraethoxysilane). Parameters affecting on the particle diameter in hydrolysis in an alcohol solvent are the concentration of silicon alkoxide, pH and concentration of ammonia used as a catalyst, reaction temperature, the kind (molecular weight) of the alcohol solvent, reaction time or the like. A dispersion solution of colloidal silica having a desired particle diameter and degree of aggregation can be obtained by adjusting these parameters.

While the metal oxide dissolving agent in the invention is not particularly limited, examples of the agent include organic acids, organic acid esters, ammonium salts of the organic acid, inorganic acids and ammonium salts of the inorganic acid. Formic acid, malonic acid, malic acid, tartaric acid, citric acid, salicylic acid, adipic acid, phthalic acid and polyacrylic acid are suitable in terms of effective suppression of the etching speed while a practical CMP speed is maintained, while sulfuric acid is suitable in terms of high CMP speed, for the conductive substance mainly comprising a metal. One of these agents may be used alone, or a mixture of a plurality of them may be used.

While the metal corrosion preventive agent of the invention is not particularly limited, examples of the agent include compounds having a triazole frame, compounds having a pyrazole frame, compounds having a pyramidine frame, compounds having an imidazole frame, compounds having a guanidine frame and compounds having a thiazole frame. One of these compounds may be used alone, or a mixture of a plurality of them may be used. The heterocyclic compound included in compound (B) of the additives for reducing the potential difference may be also used as the metal corrosion preventive agent.

A metal oxidizing agent may be blended in the polishing slurry for CMP of the invention. Examples of the metal oxidizing agent include hydrogen peroxide, nitric acid, potassium periodate, hypochlorous acid and aqueous ozone, and hydrogen peroxide is preferable among them. One of these agents may be used alone, or a mixture of a plurality of them may be used. Since contamination with alkali metals, alkali earth metals or halogenated compounds is not desirable when the substrate is a silicon substrate comprising elements for integrated circuits, oxidizing agents not containing any non-volatile components are desirable. Hydrogen peroxide is most suitable since aqueous ozone exhibits vigorous changes of the composition with time. However, an oxidizing agent containing non-volatile components may be used when the polishing surface is a substrate such as a glass substrate having no semiconductor elements.

Solvents may be blended with the polishing slurry for CMP of the invention. While the solvent for the polishing slurry for CMP of the invention is not particularly limited, it is preferably an organic solvent freely mixable with water. Examples of the solvent include glycols, glycol monoethers, glycol diethers, alcohols, carbonic acid esters, lactones, ethers, ketones as well asphenols,dimethylformamide,n-methylpyrrolidone,ethylacetate, ethyl lactate and sulfolane; preferably at least one selected from glycol monoethers, alcohols and carbonic acid esters.

When the additive for reducing the potential difference is blended with the polishing slurry of the invention, the amount of addition of the additive is preferably in the range from 0.001 to 10 g, more preferably from 0.005 to 5 g, and particularly 0.01 to 1 g per 100 g of the polishing slurry. The effect for reducing the absolute value of the potential difference tends to be lowered when the amount of blending is less than 0.001 g, while planarity of the patterned wafer after polishing tends to be impaired due to slow polishing speed when the amount of blending exceeds 10 g.

The amount of blending of the abrasive grains of the invention is preferably in the range from 0.01 to 50 g, more preferably from 0.02 to 20 g, and particularly from 0.05 to 10 g per 100 g of the polishing slurry when the abrasive grains are blended with the polishing slurry. The polishing speed tends to be lowered when the amount of blending is less than 0.01 g, while incidence of the scratchs tends to be increased when the amount of blending exceeds 50 g.

The amount of blending of the metal oxide dissolving agent in the invention is preferably from 0.001 to 20 g, more preferably from 0.002 to 10 g, and particularly from 0.005 to 5 g, per 100 g of the polishing slurry when the metal oxide dissolving agent is blended with the polishing slurry. The polishing speed tends to be lowered when the amount is less than 0.001 g, while the polished surface tends to be rough due to difficulty of control of etching when the amount exceeds 20 g.

The amount of blending of the metal corrosion preventive agent of the invention is preferably in the range from 0 to 10 g (excluding 0 g), more preferably from 0.001 to 5 g, and particularly preferably from 0.002 to 2 g, per 100 g of the polishing slurry when the metal corrosion preventive agent is blended with the polishing slurry. The polishing speed tends to be lowered when the amount of blending exceeds 10 g.

The amount of blending of the metal oxidizing agent is preferably in the range from 0.01 to 50 g, more preferably from 0.02 to 20 g, and particularly preferably from 0.05 to 10g per 100 g of the polishing slurry when the metal oxidizing agent is blended with the polishing slurry. CMP speed tends to be lowered due to insufficient oxidation of metals when the amount of blending is less than 0.01 g, while the polished surface tends to be roughened when the amount exceeds 50 g.

The amount of blending of the organic solvent is preferably in the range from 0.1 to 95 g, more preferably from 0.2 to 50 g, and particularly preferably from 0.5 to 10 g per 100 g of the polishing slurry when the organic solvent is blended with the polishing slurry. Wettability of the polishing slurry to the substrate tends to be lowered when the amount of blending is less than 0.1 g, while an amount exceeding 95 g is not preferable for the production process since risk of catching fire increases. The amount of blending of water is not particularly limited.

The polishing slurry of the invention may comprise a water soluble polymer, colorant and the like, if necessary, in addition to the above-mentioned components.

The above-mentioned polishing slurry can be applied for forming a wiring layer of the semiconductor device. For example, the polishing slurry may be used for chemical mechanical polishing (CMP) of the conductive substance layer, barrier layer and interlayer insulation film. The polishing method of the invention comprises the steps of: exposing the barrier layer of convex portions by polishing the conductive substance layer of a substrate comprising an interlayer insulation film having concave portions and convex portions on the surface, the barrier layer for covering the interlayer insulation film along the surface thereof, and the conductive substance layer for covering the barrier layer and filling the concave portion (a first polishing step) ; and planarizing by polishing at least the barrier layer and conductive substance layer of concave portions, and by polishing the interlayer insulation film, if necessary (a second polishing step). The substrate is polished by chemical mechanical polishing in the second polishing step by supplying the polishing slurry of the invention.

An example of chemical mechanical polishing is to polish the surface by relative movement between a polishing platen and the substrate while supplying the polishing slurry with the substrate having the polishing surface pressed onto a polishing cloth (pad) of the polishing platen. The planarizing method includes allowing a metal or resin brush to contact the polishing surface, or blowing the polishing slurry onto the polishing surface at a predetermined pressure.

An example of the conductive substance is, as hitherto described, a substance mainly comprising a metal, preferably conductive substance (a), andmorepreferablycopper. A film formed by a conventional sputtering method or plating method of the above-mentioned substance may be used as the conductive substance layer.

An example of the barrier layer comprises, as hitherto described, tungsten, titanium or other conductors (b), and a laminated layer including the barrier layer.

An example of the interlayer insulation film is a silicon base coated film or an organic polymer film. Examples of the silicon base coated film include silicon dioxide, fluorosilicate glass, an organosilicate glass obtained by using trimethylsilane or dimethoxysilane as a starting material; a silica base coated film of silicon oxynitride or hydrogenated silsesquioxane; and silicon carbide and silicon nitride. An example of the organic polymer film is a total aromatic-low dielectric constant interlayer insulation film. An organosilicate glass is particularly preferable. These films can be deposited by a CVD method, spin-coat method, dip-coat method or spray method.

A generally used polishing apparatus can be used, for example, as a polishing apparatus for polishing with a polishing cloth, wherein the apparatus comprises a holder for folding a substrate to be polished, and a platen connected to a rotation speed variable motor and capable of bonding the polishing cloth. Generally used nonwoven fabric, polyurethane foam or porous fluorinated resin may be used as the polishing cloth, and the material is not particularly limited. While the polishing condition is not particularly limited, a low rotation speed of the platen of 200 rpm or less is preferable so that the substrate does not jump out of the platen. The pressure for pressing the polishing cloth onto the semiconductor substrate having a polishing surface (polishing pressure) is preferably in the range from 1 to 100 kPa, and more preferably from 5 to 50 kPa for satisfying uniformity of the CMP speed on the surface and planarity of the pattern. The polishing slurry for CMP is continuously supplied to the polishing cloth during the period of polishing. While the amount of supply is not limited, it is preferable that the surface of the polishing cloth is always covered with the polishing slurry. Water drops adhered on the substrate are preferably thrown off and dried using a spin dryer or the like after washing the substrate in running water after polishing. A conditioning step of the polishing cloth is preferably inserted before polishing for chemical mechanical polishing under the same surface condition of the polishing cloth. For example, the polishing cloth is conditioned with a liquid containing at least water using a dresser to which diamond particles adhere. Subsequently, the chemical mechanical polishing step is applied, preferably followed by a cleaning step of the substrate.

The polishing method of the invention can be applied, for example, for forming the wiring layer in the semiconductor device. The embodiment of the polishing method of the invention will be described below along with the formation of the wiring layer in the semiconductor device.

The interlayer insulation film of silicon dioxide or the like is laminated on a silicon substrate at first. Then, the interlayer insulation film is processed to have concave and convex portions by forming the concave portions having a predetermined pattern on the surface of the interlayer insulation film by known methods such as forming a resist layer and etching. A barrier layer such as tantalum layers for covering the interlayer insulation film along the concave and convex pattern of the surface is deposited on the interlayer insulation film by deposition or CVD. Then, a conductive substance layer of a metal such as copper for covering the barrier layer is formed by deposition, plating or CVD so as to fill the concave portion. The thickness of the interlayer insulation film, the thickness of the barrier layer and the thickness of the conductive substance layer are preferably in the range from about 0.01 to 2.0 µm, from about 1 to 100 nm and from about 0.01 to 2.5 µm, respectively.

Subsequently, the conductive substance layer on the surface of the semiconductor substrate is polished by CMP using polishing slurry, for example, for the conductive substance having a sufficiently large polishing speed ratio between the conductive substance layer and barrier layer (first polishing step). Consequently, a desired conductor pattern is obtained wherein the barrier layer on the convex portion on the substrate is exposed on the surface, and the conductive substance film remained in the concave portion. The patterned surface thus obtained can be polished as the polishing surface for the second polishing step using the polishing slurry.

In the second polishing step, at least the exposed barrier layer and conductive substance layer in the concave portion are polished by chemical mechanical polishing using the polishing slurry of the invention for polishing the conductive substance layer, barrier layer and interlayer insulation film. Polishing is completed when a desired pattern is obtained wherein the entire interlayer insulation film under the barrier layer in the convex portion is exposed, the conductive substance layer to be the wiring layer remains in the concave portion ,and cross sections of the barrier layer is exposed at the boundaries between the convex and concave portions. Polishing may be continued at a depth including a part of the interlayer insulation film in the convex portion by over-polishing in order to secure more excellent planarity after completing polishing (for example, when a time period of 100 seconds is necessary for obtaining the desiredpattern in the secondpolishing step and polishing is further continued for 50 seconds in addition to the polishing for 100 seconds, this is called 50% over-polishing) .

An interlayer insulation film and second metal wiring lines are further formed on the metal wiring line thus formed, another interlayer insulation film is formed between the wiring lines and on the wiring line, and the entire surface of the semiconductor substrateissmoothened by polishing. A semiconductor device having a desired number of wiring layers can be produced by repeating a certain number of the above-mentioned steps.

The polishing slurry of the invention can be also used for polishing other substrates such as a magnetic head not only for polishing the metal films formed on the semiconductor substrate as described above.

### EXAMPLES

While the invention is described with reference to examples, the invention is by no means limited to these examples.

### (Method for preparing polishing slurry)

Polishing slurry for CMPs used in Examples 1 to 30 and Comparative Examples 1 to 8 were prepared by blending starting materials shown in Tables 1 to 6 in respective blending ratios.

**Table 1**

| material (part by mass) | | Example | | | | | | | |
|---|---|---|---|---|---|---|---|---|---|
| | | 1 | 2 | 3 | 4 | 5 | 6 | 7 | 8 |
| abrasive grain | silica particles | 8 | 8 | 8 | 8 | 8 | 8 | 8 | 8 |
| metal oxide dissolving agent | succinic acid | 0.25 | 0.25 | 0.25 | - | - | - | - | - |
| | salicylic acid | - | - | - | 0.25 | 0.25 | - | - | - |
| | malic acid | - | - | - | - | - | 0.5 | 0.5 | 0.5 |
| additive for reducing absolute value of potential difference between barrier conductor and copper | N-methyldiethanolamine | 0.1 | - | - | 0.05 | - | 0.1 | - | - |
| | 1-hydroxy-benzotriazole | - | 0.2 | - | 0.1 | 0.1 | - | 0.1 | - |
| | pyrazine carboxylic acid | - | - | 0.2 | - | 0.1 | - | - | 0.2 |
| metal corrosion preventive agent | imidazole | 0.02 | 0.02 | 0.02 | - | - | - | - | - |
| | 7-hydroxy-5-methyl-2,3a)-triazopyrimidine | - | - | - | 0.01 | 0.01 | - | - | - |
| | 3,5-dimethylpyrazole | - | - | - | - | - | 0.01 | 0.01 | 0.01 |
| oxidizing agent | hydrogen peroxide | 0.5 | 0.5 | 0.5 | 0.5 | 0.5 | 0.5 | 0.5 | 0.5 |
| water | | 91.1 | 91.0 | 91.0 | 91.1 | 91.0 | 90.9 | 90.9 | 90.8 |

**Table 2**

| material (part by mass) | | Example | | | | | |
|---|---|---|---|---|---|---|---|
| | | 9 | 10 | 11 | 12 | 13 | 14 |
| abrasive grain | silica particles | 8 | 8 | 8 | 8 | 8 | 8 |
| metal oxide dissolving agent | succinic acid | 0.25 | 0.25 | 0.25 | 0.25 | - | - |
| | salicylic acid | - | - | - | - | 0.25 | 0.25 |
| | malic acid | - | - | - | - | - | - |
| additive for reducing absolute value of potential difference between barrier conductor and copper | N-methyldiethanolamine | 0.05 | - | - | - | - | - |
| | N,N-dimethylethanolamine | - | 0.1 | - | - | - | - |
| | triethanolamine | - | - | 0.1 | - | - | - |
| | n-butylamine | - | - | - | 0.1 | - | - |
| | hexamethyl phosphoric triamide | - | - | - | - | 0.1 | - |
| | aniline | - | - | - | - | - | 0.1 |
| | monoethanolamine | - | - | - | - | - | - |
| | cyclohexylamine | - | - | - | - | - | - |
| | dimethylacetamide | - | - | - | - | - | - |
| | dimethylsulfoxide | - | - | - | - | - | - |
| metal corrosion preventive agent | imidazole | - | - | - | - | - | - |
| | 7-hydroxy-5-methyl-(23a) -triazo pyrimidine | - | - | - | - | 0.01 | 0.01 |
| | 3,5-dimethyl pyrazole | 0.01 | 0.01 | 0.01 | 0.01 | - | - |
| oxidizing agent | hydrogen peroxide | 0.5 | 0.5 | 0.5 | 0.5 | 0.5 | 0.5 |
| water | | 91.2 | 91.1 | 91.1 | 91.1 | 91.1 | 91.1 |

**Table 3**

| material (part by mass) | | Example | | | | | |
|---|---|---|---|---|---|---|---|
| | | 15 | 16 | 17 | 18 | 19 | 20 |
| abrasive silica particles grain | | 8 | 8 | 8 | 8 | 8 | 8 |
| metal oxide dissolving agent | succinic acid | - | - | - | - | - | - |
| | salicylic acid | 0.25 | 0.25 | - | - | - | - |
| | malic acid | - | - | 0.25 | 0.25 | 0.25 | 0.25 |
| additive for reducing absolute value of potential difference between barrier conductor and copper | N-methyl diethanolamine | - | - | - | - | 0.05 | 0.05 |
| | N,N-dimethylethanolamine | - | - | - | - | 0.05 | - |
| | triethanolamine | - | - | - | - | - | 0.05 |
| | n-butylamine | - | - | - | - | - | - |
| | hexamethyl phosphoric triamide | - | - | - | - | - | - |
| | aniline | - | - | - | - | - | - |
| | monoethanolamine | 0.1 | - | - | - | - | - |
| | cyclohexylamine | - | 0.1 | - | - | - | - |
| | dimethylacetamide | - | - | 0.1 | - | - | - |
| | dimethylsulfoxide | - | - | - | 0.1 | - | - |
| metal corrosion preventive agent | imidazole | - | - | 0.02 | 0.02 | 0.02 | 0.02 |
| | 7-hydroxy-5 -methyl-(2,3a) -triazopyrimidine | 0.01 | 0.01 | - | - | - | - |
| | 3,5-dimethyl pyrazole | - | - | - | - | - | - |
| oxidizing agent | hydrogen peroxide | 0.5 | 0.5 | 0.5 | 0.5 | 0.5 | 0.5 |
| water | | 91.1 | 91.1 | 91.1 | 91.1 | 91.1 | 91.1 |

**Table 4**

| material (part by mass) | | Example | | | | |
|---|---|---|---|---|---|---|
| | | 21 | 22 | 23 | 24 | 25 |
| abrasive grain | silica particles | 8 | 8 | 8 | 8 | 8 |
| metal oxide dissolving agent | succinic acid | 0.25 | 0.25 | 0.25 | - | - |
| | salicylic acid | - | - | - | 0.25 | 0.25 |
| | malic acid | - | - | - | - | - |
| additive for reducing absolute value of potential difference between barrier conductor and copper | N-methyldiethanolamine | 0.1 | 0.1 | 0.1 | 0.1 | 0.1 |
| | 2-amino-2-thiazoline acetic acid | 0.2 | - | - | - | - |
| | pyrazine carboxyamide | - | 0.2 - | - | - | - |
| | 4-amino-1,2,4-triazole | - | - | 0.2 | - | - |
| | 1,2,4-triazol -3-one | - | - | - | 0.2 | - |
| | 2,3-pyrazine dicarboxylic acid | - | - | - | - | 0.2 |
| metal corrosion preventive agent | imidazole | - | - | - | - | - |
| | 7-hydroxy-5-methyl-(2,3a)triazopyrimidine | - | - | - | 0.01 | 0.01 |
| | 3,5-dimethyl pyrazole | 0.01 | 0.01 | 0.01 | - | - |
| oxidizing agent | hydrogen peroxide | 0.5 | 0.5 | 0.5 | 0.5 | 0.5 |
| water | | 90.9 | 90.9 | 90.9 | 90.9 | 90.9 |

**Table 5**

| material (part by mass) | | Example | | | | |
|---|---|---|---|---|---|---|
| | | 26 | 27 | 28 | 29 | 30 |
| abrasive grain | silica particles | 8 | 8 | 8 | 8 | 8 |
| metal oxide dissolving agent | succinic acid | - | - | - | - | - |
| | salicylic acid | 0.25 | - | - | - | - |
| | malic acid | - | 0.25 | 0.25 | 0.25 | 0.25 |
| additive for reducing absolute value of potential difference between barrier conductor and copper | N-methyldiethanolamine | - | - | - | - | - |
| | 2-amino-2-thiazoline acetic acid | 0.2 | - | - | - | - |
| | pyrazine carboxyamide | - | 0.2 | - | - | - |
| | 4-amino-1,2,4-triazole | - | - | 0.2 | - | - |
| | 1,2,4-triazol-3-one | - | - | - | 0.2 | - |
| | 2,3-pyrazine dicarboxylic acid | - | - | - | - | 0.2 |
| metal corrosion preventive agent | imidazole | - | 0.02 | 0.02 | 0.02 | 0.02 |
| | 7-hydroxy-5-methyl-(2,3a) -triazopyrimidine | 0.01 | - | - | - | - |
| | 3,5-dimethyl pyrazole | - | - | - | - | - |
| oxidizing agent | hydrogen peroxide | 0.5 | 0.5 | 0.5 | 0.5 | 0.5 |
| water | | 91.0 | 91.0 | 91.0 | 91.0 | 91.0 |

**Table 6**

| material (part by mass) | | Comparative Example | | | | | | | |
|---|---|---|---|---|---|---|---|---|---|
| | | 1 | 2 | 3 | 4 | 5 | 6 | 7 | 8 |
| abrasive grain | silica particles | 8 | 8 | 8 | 8 | 8 | 8 | 8 | 8 |
| metal oxide dissolving agent | salicylic acid | 0.25 | 0.25 | - | - | 0.25 | 0.25 | - | - |
| | malic acid | - | - | 0.5 | 0.5 | - | - | 0.5 | 0.5 |
| metal corrosion preventive agent | 3-methyl-5-pyrazolone | - | - | - | - | 0.2 | - | 0.2 | - |
| | Benzotriazole | - | - | - | - | - | 0.2 | - | 0.2 |
| | 3,5-dimethyl pyrazole | 0.01 | - | 0.01 | - | 0.01 | 0.01 | 0.01 | 0.01 |
| | imidazole | - | 0.02 | - | 0.02 | - | - | - | - |
| oxidizing agent | hydrogen peroxide | 0.5 | 0.5 | 0.5 | 0.5 | 0.5 | 0.5 | 0.5 | 0.5 |
| water | | 91.2 | 91.2 | 91.0 | 91.0 | 91.0 | 91.0 | 90.8 | 90.8 |

### (Measurement of potential difference)

FIGURE shows a schematic illustration of an example for measuring the potential difference. As shown in FIGURE, about 50 ml of various polishing slurry for CMPs 2 prepared as described above were poured into 100 ml glass beaker 1, and the liquid was kept at 50°C ± 5°C in a constant temperature bath. A silicon substrate on which a copper film with a thickness of 1600 nm was deposited by sputtering (referred to as a copper substrate 4 hereinafter) and a silicon substrate on which a tantalum nitride film with a thickness of 200 nm was deposited by sputtering (referred to as a barrier conductor substrate 3 hereinafter) were cut into a size of 15 mm × 75 mm, and a positive electrode of a potentiometer 5 was connected to the copper substrate 4 and negative electrode was connected to barrier conductor substrate 3. Then, the minimum value of the potential difference was measured in the period of 30 seconds after immersing the substrates in the polishing slurry for CMP 2 while the copper substrate and barrier conductor substrate were placed with a distance apart so as to avoid them from being in contact to one another. The results of the measurement of the potential difference of the samples in Examples 1 to 30 and Comparative Examples 1 to 8 are shown in Tables 7 and 8.

### (Measurement of solubility of copper complex)

An appropriate amount of copper (II) sulfate was added to the polishing slurry for CMPs prepared in Examples 2 to 5, 7, 8 and 21 to 30 and Comparative Examples 1 and 5 to 8 by blending as described in Tables 1 to 6, and precipitates in the vessel, if any, were confirmed. Details of the measurement in Comparative Example 5 and Example 2 are described below.

### (Comparative Example 5)

Copper (II) sulfate pentahydrate (2.6 g) was added to 1000 g of the polishing slurry for CMP blended as described in Comparative Example 5 in Table 6. Green precipitates were observed after 60 minutes' standing by maintaining the temperature of the solution at 25°C after thoroughly stirring the solution. Since the quantity of the complex of generated copper and 3-methyl-5-pyrazolone was estimated to be about 2.7 g, and the green precipitate is supposed to be a complex between copper and 3-methyl-5-pyrazolone. It was shown from the result that the solubility in the polishing slurry of the copper complex formed by adding copper sulfate to the polishing slurry is less than 0.27% by weight at a temperature of 25°C.

### (Example 2)

Copper (II) sulfate pentahydrate (1.85 g) was added to 1000 g of the polishing slurry for CMP blended as described in Example 2 in Table 1, but no precipitates were observed after 60 minutes' standing by keeping the temperature of the liquid at 25 °C after thoroughly stirring the solution. The quantity of the complex formed between generated copper and 1-hydroxybenzotriazole is estimated to be about 2.5 g. Subsequently, the liquid was concentrated in a vacuum drier to a quantity of 200 g, and the liquid was kept standing for 60 minutes by maintaining the temperature at 25°C. However, no precipitates were observed. Consequently, the solubility of the complex formed by adding copper sulfate to the polishing slurry was shown to be 1.25% by weight or more at 25°C in the polishing slurry.

Solubility of each copper complex in Examples 2 to 5, 7, 8 and 21 to 30 and in Comparative Examples in 1 and 5 to 8 was measured as described above and evaluated as follows. The results are shown in Tables 7 and 8.

Good (O): solubility of the copper complex is 1% by weight or more at 25°C;
Poor (×): solubility of the copper complex is less than 1% by weight at 25°C; and
None (-): not evaluated.

### (Polishing of patterned substrate)

Protruded projections of copper film SEMATECH 854 CMP 200 (manufactured by Semiconductor Manufacturing Technology) were polished by a conventional method, and the barrier layer of the convex portion was exposed on the polished surface (first polishing step). This substrate was used for polishing as described below.

### (Polishing conditions)

Polishing pad: foamed polyurethane resin (No. IC1000, manufactured by Rodel Inc.)
Polishing pressure: 14 kPa
Relative velocity between substrate and polishing platen: 70 m/min
Feed rate of polishing slurry: 200 ml/min

### (Polishing step of substrate)

The above-mentioned patterned substrate was subjected to chemical mechanical polishing with the polishing slurry for CMP prepared as described above for 60 seconds under the above-mentioned condition. This corresponds to the second polishing step. The entire interlayer insulation film of convex portions was exposed on the polished surface by polishing for 20 seconds, and in remaining 40 seconds, polishing in the convex portion was the polishing of the interlayer insulation film.

### (Washing step of substrate)

A sponge brush (made of polyvinyl alcohol resin) was pressed onto the polished surface of the patterned substrate polished as described above, and the surface was washed for 90 seconds by rotating the sponge brush and substrate while distilled water was supplied to the substrate. Then, the sponge brush was removed, and distilled water was supplied on the polished surface of the substrate for 60 seconds. Finally, distilled water was repelled away by rotating the substrate at a high speed to dry the substrate.

### (Evaluation items)

The patterned wafer after washing was evaluated as in (1) and (2) below. The results are shown in Tables 7 and 8.

(1) Corrosion of copper wiring line: Isolated fine wiring part with a line width from 0.2 to 0.5 µm was observed using a length measuring scanning electron microscope to examine corrosion of the wiring lines, and the results were evaluated as follows:

excellent (⊚): in good condition with no corrosion;
good (○): although slight corrosion was observed at the tip, generally in good condition;
not good (Δ) : corrosion was observed at the tip, and slight corrosion was observed at the boundary between the wiring line and barrier layer; and
poor (×) : many corroded portions were observed at the boundary between the wiring line and barrier layer in addition to corrosion at the tip.

(2) Planarity (amount of dishing): Loss of the film (inǺ unit) of the wiring metal portion relative to the interlayer insulation film was determined with a stylus step height meter from the surface shape of striped patterns in which wiring metal (copper) lines (a width of 100 µm) and interlayer insulation films (a width of 100 µm) are alternately aligned on the patterned substrate.

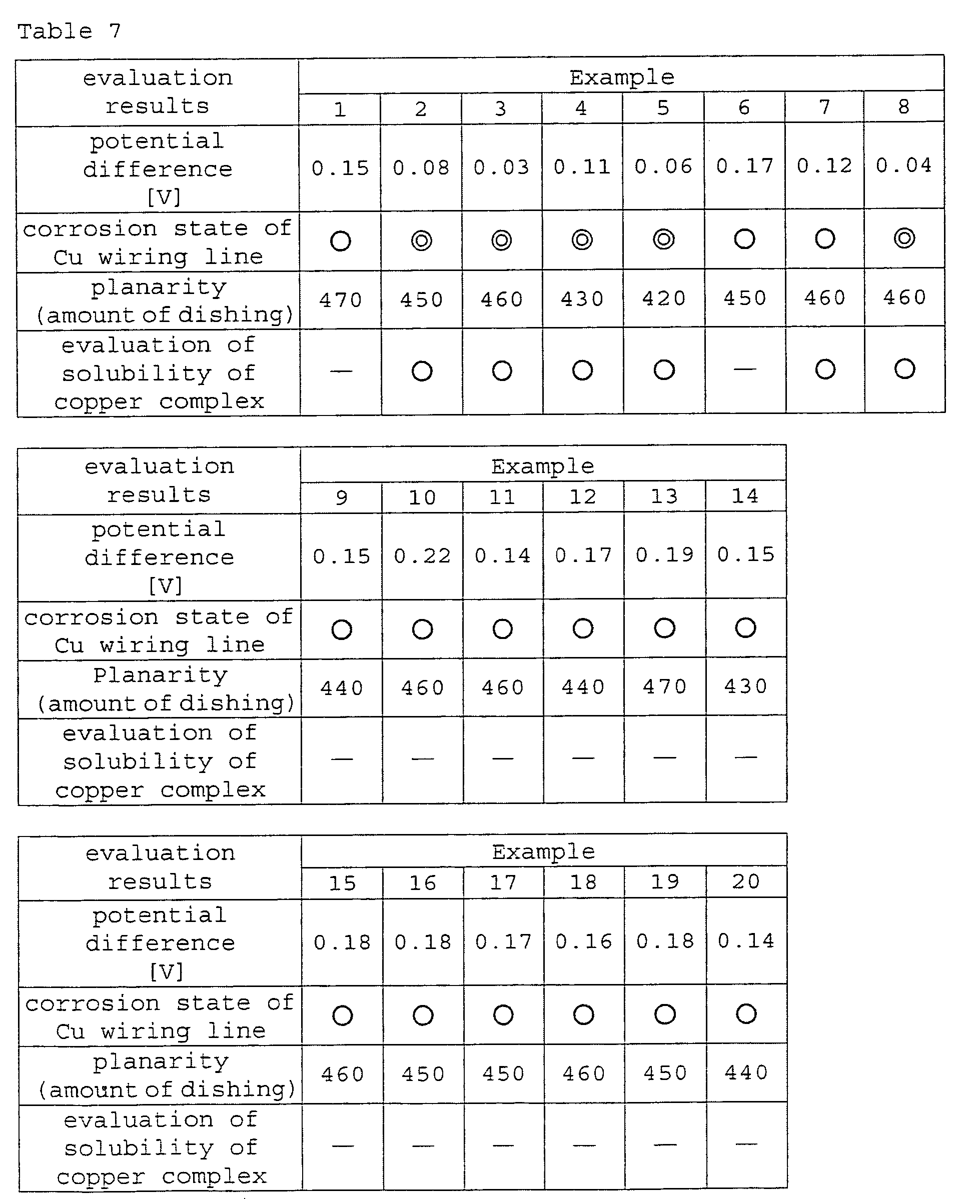

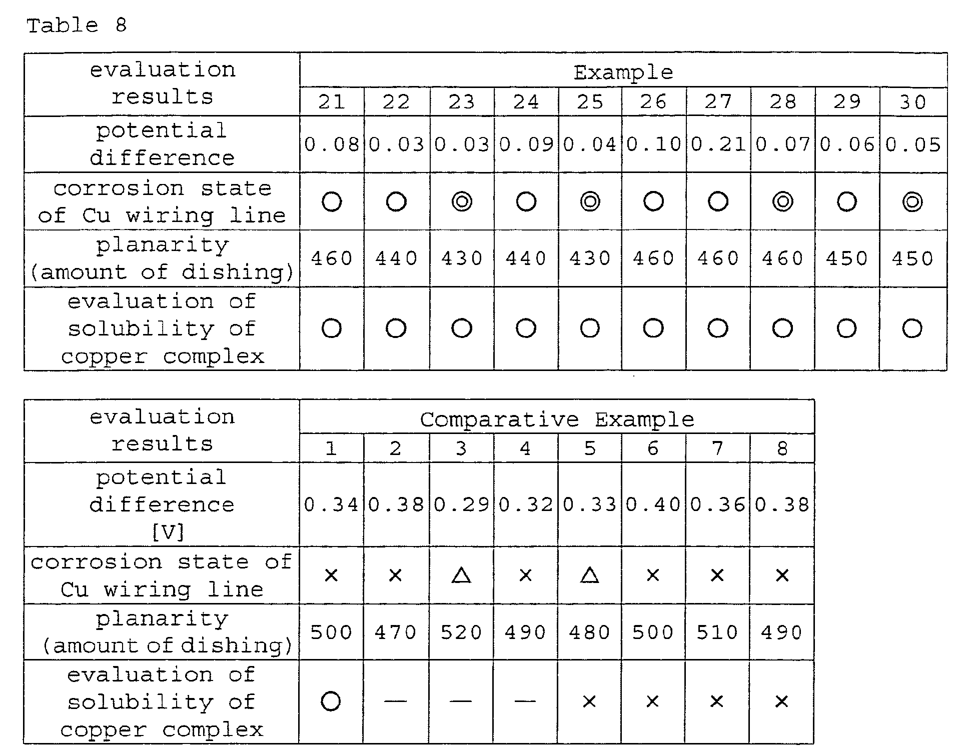

As shown in Tables 7 and 8, the potential difference exceeded 0.25 V while many corroded portions were observed not only at the tips of the fine copper wiring lines with a width from 0.2 to 0.5 microns but also at the boundary between the copper wiring line and barrier layer in Comparative Examples 1 to 8. On the contrary, the potential difference was 0.25 V or less with a good condition with respect to corrosion of the copper wiring line in Examples 1 to 30. Planarity was also good with a small amount of dishing.

### Industrial Applicability

The polishing slurry for CMP of the invention affords a corrosion suppressing effect for fine wiring portions of the conductive substance on a patterned substrate, particularly fine wiring portions having a width of 0.5 µm or less that are liable to be severely corroded. The patterned substrate is also excellent in planarity. The polishing method of the invention for chemical mechanical polishing using the polishing slurry for CMP is able to enhance productivity and to form fine wiring lines excellent in fining and thinning effects, and dimensional accuracy and electric characteristics, and is suitable for manufacturing a semiconductor device and other electronic appliances excellent in high reliability.

Excellent planarity may be formed using the polishing slurry since the polishing speed ratio between the barrier layer, wiring lines of the conductive substance and interlayer insulation film can be adjusted. The invention also provides a polishing method for producing a semiconductor device or the like excellent in the fining and thinning effects, excellent in dimensional accuracy and having high reliability with low cost.

## Claims

1. Polishing slurry for CMP for polishing at least a conductor layer and a conductive substance layer in contact with the conductor layer, wherein
the absolute value of the potential difference between the conductive substance and conductor at 50 ± 5°C is 0.25 V or less in the polishing slurry when a positive electrode and a negative electrode of a potentiometer are connected to the conductive substance and conductor, respectively.

2. The polishing slurry for CMP according to Claim 1 comprising an additive for reducing the absolute value of the potential difference between the conductor and conductive substance.

3. The polishing slurry for CMP according to Claim 2 comprising, as the additive for reducing the absolute value of the potential difference, at least one compound selected from heterocyclic compounds containing any one of hydroxyl group, carbonyl group, carboxyl group, amino group, amide group and sulfinyl group, and containing at least one of nitrogen and sulfur atoms.

4. The polishing slurry for CMP according to Claim 3, wherein the solubility in the polishing slurry of a copper complex of the heterocyclic compound formed by adding copper (II) sulfate to the polishing slurry is 1% by weight or more at a liquid temperature of 25°C.

5. The polishing slurry for CMP according to Claim 2 comprising at least one compound selected from amine compounds, amide compounds and sulfoxide compounds as the additive for reducing the absolute value of the potential difference.

6. The polishing slurry for CMP according to any one of Claims 3 to 5 comprising at least one compound selected from heterocyclic compounds containing any one of hydroxyl group, carbonyl group, carboxyl group, amino group, amide group and sulfinyl group, and containing at least one of nitrogen and sulfur atoms, and at least one compound selected from amine compounds, amide compounds and sulfoxide compounds.

7. The polishing slurry for CMP according to any one of Claims 1 to 6, wherein the conductor contains at least one selected from tantalum, tantalum nitride, tantalum alloys and other tantalum compounds, titanium, titanium nitride, titanium alloys and other titanium compounds, tungsten, tungsten nitride, tungsten alloys and other tungsten compounds, ruthenium and other ruthenium compounds; and the conductive substance is copper, copper alloys, copper oxides, oxides of the copper alloy, tungsten, tungsten alloys, silver, silver alloys or gold.

8. The polishing slurry for CMP according to any one of Claims 1 to 7, wherein the conductive substance is copper.

9. Polishing slurry for CMP forpolishing a surface comprising, on the surface thereof,
(a) a conductive substance mainly comprising copper; and
(b) at least one conductor selected from tantalum, tantalum nitride, tantalum alloys and other tantalum compounds, titanium, titanium nitride, titanium alloys and other titanium compounds, tungsten, tungsten nitride, tungsten alloys and other tungsten compounds, ruthenium and other ruthenium compounds,
wherein the absolute value of the potential difference between (a) the conductive substance and (b) the conductor at 50 ± 5°C is 0.25 V or less in the polishing slurry when a positive electrode of a potentiometer is connected to (a) the conductive substance and a negative electrode is connected to (b) the conductive substance.

10. Polishing slurry for CMP for polishing a substrate comprising an interlayer insulation film having concave portions and convex portions on the surface, a barrier conductor layer for covering the interlayer insulation film along the surface thereof, and a conductive substance layer mainly comprising copper for covering the barrier conductor layer and f illing the concave portion,
wherein the polishing slurry comprises at least one heterocyclic compounds comprising any one of hydroxyl group, carbonyl group, carboxyl group, amino group, amide group and a sulfinyl group, and comprising at least one of nitrogen and sulfur atoms.

11. Polishing slurry for CMP for polishing a surface comprising, on the surface thereof,
(a) a conductive substance mainly comprising copper, and
(b) at least one conductor selected from tantalum, tantalum nitride, a tantalum alloy, other tantalum compounds, titanium, titanium nitride, a titanium alloy, other titanium compounds, tungsten, tungsten nitride, a tungsten alloy, other tungsten compounds, ruthenium and other ruthenium compounds,
wherein the polishing slurry comprises at least one heterocyclic compounds containing any one of a hydroxyl group, carbonyl group, carboxyl group, amino group, amide group and sulfinyl group, and containing at least one selected from nitrogen and sulfur atoms.

12. Polishing slurry for CMP for polishing a substrate comprising an interlayer insulation film having convex portions and concave portions on the surface, a barrier conductor layer for covering the interlayer insulation film along the surface thereof, and a conductive substance layer mainly comprising copper for covering the barrier conductor layer and filling the concave portion,
the polishing slurry comprising at least one compound selected from amine compounds, amide compounds and sulfoxide compounds.

13. Polishing slurry for CMP for polishing a surface comprising,
(a) a conductive substance mainly comprising copper, and
(b) at least one conductor selected from tantalum, tantalum nitride, tantalum alloys and other tantalum compounds, titanium, titanium nitride, titanium alloys and other titanium compounds, tungsten, tungsten nitride, tungsten alloys and other tungsten compounds, ruthenium and other ruthenium compounds,
the polishing slurry comprising at least one compound selected from amine compounds, amide compounds and sulfoxide compounds.

14. The polishing slurry for CMP according to anyone of Claims 1 to 13 comprising abrasive grains.

15. The polishing slurry for CMP according to Claim 14, wherein the abrasive grains are at least one selected from silica, alumina, ceria, titania, zirconia and germania.

16. The polishing slurry for CMP according to anyone of Claims 1 to 15 comprising a metal oxide dissolving agent and water.

17. The polishing slurry for CMP according to Claim 16, wherein the metal oxide dissolving agent is at least one compound selected from organic acids, organic acid esters, ammonium salts of organic acids and inorganic acids.

18. The polishing slurry for CMP according to anyone of Claims 1 to 17 comprising a metalcorrosion preventive agent.

19. The polishing slurry for CMP according to Claim 18, wherein the metal corrosion preventive agent is at least one compound selected from compounds having a triazole frame, compounds having a benzotriazole frame, compounds having a pyrazole frame, compounds having a pyramidine frame, compounds having an imidazole frame, compounds having a guanidine frame and compounds having a thiazole frame.

20. The polishing slurry for CMP according to anyone of Claims 1 to 19 containing a metal oxidizing agent.

21. The polishing slurry for CMP according to Claim 20, wherein the metal oxidizing agent is at least one selected from hydrogen peroxide, nitric acid, potassium periodate, hypochlorous acid and aqueous ozone.

22. A polishing method comprising the steps of:
exposing a barrier conductor layer of convex portions by polishing a conductive substance layer of a substrate comprising an interlayer insulation film having concave portions and convex portions on the surface, a barrier conductor layer for covering the interlayer insulation film along the surface thereof, and a conductive substance layer for covering the barrier conductor layer and filling the concave portion (a first polishing step); and
exposing the interlayer insulation film of the convex portion by chemical mechanical polishing of at least the barrier layer and conductive substance layer in the concave portion while supplying the polishing slurry for CMP according to any one of Claims 1 to 21(a second polishing step).

23. The polishing method according to Claim 22, wherein the interlayer insulation film is a silicon film or an organic polymer film.

24. The polishing method according to Claim 22 or 23, wherein the conductive substance mainly comprises copper.

25. The polishing method according to any one of Claims 22 to 24, wherein the barrier conductor layer is provided for preventing the conductive substance from being diffused into the interlayer insulation film, and contains at least one selected from tantalum, tantalum nitride, tantalum alloys and other tantalum compounds, titanium, titanium nitride, titanium alloys and other titanium compounds, tungsten, tungsten nitride, tungsten alloys and other tungsten compounds, ruthenium and other ruthenium compounds.
